(19) Europäisches Patentamt

European Patent Office

Office européen des brevets

(11) EP 0 696 743 B1

(12) EUROPÄISCHE PATENTSCHRIFT

(45) Veröffentlichungstag und Bekanntmachung des Hinweises auf die Patenterteilung:
15.12.1999 Patentblatt 1999/50

(51) Int Cl.6: G01R 33/36

(21) Anmeldenummer: 95108822.8

(22) Anmeldetag: 08.06.1995

(54) **Verfahren und automatische Hilfsvorrichtung zur Abstimmung einer NMR-Empfangsspule**

Method of and automatic auxiliary apparatus for tuning an NMR detection coil

Méthode et dispositif auxiliaire pour l'accord d'une bobine de détection RMN

(84) Benannte Vertragsstaaten:
CH DE FR GB LI

(30) Priorität: 12.08.1994 DE 4428579

(43) Veröffentlichungstag der Anmeldung:
14.02.1996 Patentblatt 1996/07

(73) Patentinhaber: Bruker AG
8117 Fällanden (CH)

(72) Erfinder:
• Busse-Grawitz, Max E.
CH-8126 Zumikon (CH)
• Malacarne, Enrico
CH-8600 Dübendorf (CH)
• Roeck, Walter
CH-8051 Zürich (CH)

(74) Vertreter: KOHLER SCHMID + PARTNER
Patentanwälte
Ruppmannstrasse 27
70565 Stuttgart (DE)

(56) Entgegenhaltungen:
WO-A-86/01905          DE-A- 3 838 252

• PATENT ABSTRACTS OF JAPAN vol. 17, no. 461
(P-1598) 23. August 1993 & JP-A-05 107 326
(JEOL LTD) 27. April 1993

**Beschreibung**

Die Erfindung betrifft ein Verfahren zum Abstimmen der Impedanz einer Empfangsspulenanordnung im Probenkopf eines NMR-Spektrometers mit einer Empfängerschaltung für ein NMR-Signal, bei welchem Verfahren mittels eines HF-Abstimmsignals die Impedanz der Empfangsspulenanordnung über ein mit einem reellen Referenzwiderstand erzeugtes erstes Referenzsignal an einem Referenzpunkt innerhalb der Empfängerschaltung abgestimmt wird.

Ein derartiges Abstimmverfahren ist beispielsweise durch die DE 38 38 252 A1 bekanntgeworden.

Bei dem bekannten Verfahren zum Abstimmen der NMR-Empfangsspule im Probenkopf eines NMR-Spektrometers wird der Probenkopf nicht von Hand vom vorhandenen NMR-Empfänger getrennt und von separaten Meßinstrumenten abgestimmt, sondern der NMR-Empfänger ist bereits mit geeigneten Vorrichtungen versehen, mit denen dieser Vorgang automatisch unter Software-Kontrolle durchgeführt werden kann. Dabei soll das Signal-zu-Rausch-Verhältnis (S/N-Verhältnis) des NMR-Empfängers im normalen Betriebszustand möglichst nicht verschlechtert werden.

Das bekannte Verfahren verwendet im wesentlichen eine HF-Abstimmquelle, welche das Signal für den Abstimmvorgang liefert, einen Referenzwiderstand und diverse Schalter, um automatisch vom normalen Betriebszustand in den Betriebszustand "Probenkopfabstimmung" und umgekehrt umzuschalten. Der Referenzwiderstand stellt die gewünschte Impedanz der Empfangsspulenanordnung dar und wird an die Stelle geschaltet, wo die Impedanz der Empfangsspulenanordnung auf den Wert des Referenzwiderstandes abgestimmt werden soll. Dieser Referenzwiderstand stellt also den gewünschten reellen Widerstand dar, den die Impedanz der Empfangsspulenanordnung annehmen sollte.

Das S/N-Verhältnis des gesamten Empfangssystems hängt stark vom Netzwerk im Pfad des NMR-Signals am Eingang des Vorverstärkers ab. Daher sollte dieses Netzwerk möglichst wenige verlustbehaftete Komponenten wie z.B. Dioden und Drosseln enthalten. Da dieses Netzwerk im allgemeinen niederohmig ist (im Bereich von $50\Omega$), sollte dort jegliche Art von Seriewiderständen, beispielsweise durchgeschaltete Dioden, vermieden werden. Bereits ein Seriewiderstand von $1\Omega$ kann zu einer merklichen Verschlechterung des S/N-Verhältnisses führen.

Durch Verwendung von pin-Dioden als Schalter lassen sich normalerweise bessere HF-Eigenschaften als mit anderen Dioden erreichen. Trotzdem besitzt eine durchgeschaltete pin-Diode immer noch einen Seriewiderstand von ca. $1\Omega$ und verursacht dadurch im leitenden Zustand nicht zu vernachlässigende HF-Verluste, beispielsweise 0,1db, was für heutige Verhältnisse bereits zuviel ist.

Im sperrenden Zustand erzeugt eine pin-Diode zwar auch HF-Verluste, die aber etwas kleiner sind als im leitenden Zustand. Sie benimmt sich im Sperrbereich wie eine kleine Kapazität von ca. 0,5pF mit einem parallel dazu liegenden Verlustwiderstand von ca. $8k\Omega$. Eine pin-Diode am Eingang des Vorverstärkers sollte deshalb im normalen Betriebszustand des Empfangssystems lieber gesperrt als leitend sein.

Eine HF-Drossel, wie sie beim Stand der Technik verwendet wird, ist auch keine ideale Komponente, denn sie besitzt eine ähnliche HF-Impedanz wie eine sperrende pin-Diode, nämlich eine Kapazität von ca. 0,5pF mit einem Parallelwiderstand von ca. $5k\Omega$.

Der vorliegenden Erfindung liegt daher die Aufgabe zugrunde, ein Verfahren der eingangs genannten Art derart weiterzubilden, daß im Pfad des NMR-Signals am Eingang des Vorverstärkers möglichst wenige Dioden, HF-Drosseln und andere Komponenten verwendet werden, die Signalverluste verursachen können. Außerdem sollen im Pfad des NMR-Signals am Eingang des Vorverstärkers während des normalen Betriebszustandes alle dort vorhandenen Dioden gesperrt sein und keine Dioden in Serie zum Pfad des NMR-Signals verwendet werden.

Diese Aufgabe wird erfindungsgemäß dadurch gelöst, daß eine Referenzimpedanz, die durch eine oder mehrere Impedanzen vom Pfad des NMR-Signals getrennt ist, so abgeglichen wird, daß ein dem ersten Referenzsignal am Referenzpunkt entsprechendes zweites Referenzsignal am Referenzpunkt entsteht, und daß anschließend die Impedanz der Empfangsspulenanordnung auf das zweite Referenzsignal am Referenzpunkt abgestimmt wird.

Bei dieser erfindungsgemäßen Erzeugung eines zweiten Referenzsignals muß der Referenzwiderstand nicht mehr an den Referenzpunkt geschaltet werden. Dadurch kann die Anzahl der Komponenten in der Empfängerschaltung reduziert werden, was zu einer Verbesserung des S/N-Verhältnisses führt.

Bei dem erfindungsgemäßen Verfahren kommt es bei der Erzeugung des Referenzsignals nur darauf an, daß sich bei abgetrenntem Eingang am Referenzpunkt ein Signalverlauf ergibt, der im gewünschten Frequenzbereich praktisch identisch ist mit dem Signalverlauf am Referenzpunkt, wenn der Eingang nicht abgetrennt und am gewünschten Abstimmort der Referenzwiderstand anstelle der Impedanz der Empfangsspulenanordnung angeschlossen wäre. Um diese Bedingung zu erfüllen, muß das HF-Abstimmsignal lediglich an einem geeigneten Ort mit Hilfe einer einstellbaren Referenzimpedanz so in seiner Amplitude und Phase geändert werden, daß am Referenzpunkt bei abgetrenntem Eingang ein zweites Referenzsignal gemäß obiger Definition erscheint.

Es ist bevorzugt, daß das erste Referenzsignal mindestens einmal bestimmt und gespeichert und daß beim Abgleichvorgang der Referenzimpedanz das zweite Referenzsignal periodisch erzeugt wird. Denn dann erscheint während der Abstimmung der Referenzimpedanz ein veränderliches Bild auf dem Bildschirm, und die Referenzimpedanz wird solange variiert, bis die auf dem Bildschirm gezeigte Differenz beider Referenzsignale im gewünschten Frequenzbereich möglichst genau Null ist. Dann ist das zweite Referenzsignal praktisch identisch dem ersten Referenzsignal, und damit kann das zweite Referenzsignal anstelle des ersten Referenzsignals zum Abstimmen der Impedanz der Empfangsspulenanordnung verwendet werden. Das zweite Referenzsignal hat den großen Vorteil, daß es mit einer Schaltanordnung gemessen werden kann, die keine merkliche Verschlechterung des S/N-Verhältnisses verursacht.

Weiterhin ist es von Vorteil, wenn das zweite Referenzsignal mindestens einmal ermittelt und beim Abstimmvorgang der Impedanz der Empfangsspulenanordnung das mit Hilfe der Impedanz der Empfangsspulenanordnung ermittelte Signal periodisch erzeugt wird. Dann erscheint während der Abstimmung der Impedanz der Empfangsspulenanordnung ein veränderliches Bild auf dem Bildschirm, das die Form einer vertikal gespiegelten Resonanzkurve besitzt. Der Abstimmvorgang ist dann abgeschlossen, wenn das Minimum dieser Resonanzkurve ungefähr Null und am gewünschten Frequenzpunkt liegt.

Da der Pegel des HF-Abstimmsignals während des Abstimmvorgangs der Impedanz der Empfangsspulenanordnung gewissen Schwankungen unterworfen sein kann, wird in einer bevorzugten Ausführungsform das zweite Referenzsignal am Anfang des Abstimmvorgangs der Impedanz der Empfangsspulenanordnung mindestens einmal neu bestimmt.

Besonders vorteilhaft ist es, wenn mittels eines zuschaltbaren Gleichstroms aus einer Spannungsquelle ein Umschalter die Funktion eines HF-Serieschalters übernimmt. Auf diese Weise lassen sich zusätzliche Komponenten am Eingang des Vorverstärkers, die man sonst für den Schalter S1 benötigt hätte, vermeiden.

In den Rahmen der Erfindung fällt außerdem eine Schaltungsvorrichtung zur Durchführung des erfindungsgemäßen Abstimmverfahrens mit einem HF-Generator zur Erzeugung des HF-Abstimmsignals und mit Schaltelementen im Pfad des NMR-Signals.

Derartige Schaltungsvorrichtungen sind ebenfalls aus der DE 38 38 252 A1 bekanntgeworden.

Bei der bekannten Schaltungsvorrichtungen werden über Relais- oder pin-Diodenschalter sowohl der Referenzwiderstand wie auch der HF-Generator zu- bzw. abgeschaltet. Über die Schalter wird die Impedanz der Empfangsspulenanordnung durch den Referenzwiderstand ersetzt, der den gewünschten reellen Widerstand darstellt, den die Impedanz der Empfangsspulenanordnung annehmen soll.

In einer erfindungsgemäßen Schaltungsvorrichtung ist die Referenzimpedanz an einem Ort innerhalb der Empfängerschaltung angeordnet, der vom Pfad des NMR-Signals durch eine oder mehrere Impedanzen getrennt ist. Beispielsweise kann eine hochohmige Koppelimpedanz an der dem HF-Generator zugekehrten Seite angeordnet sein. Dadurch wird verhindert, daß die Referenzimpedanz und der dazugehörige Schalter Verluste in den Pfad des NMR-Signals einkoppeln.

Besonders vorteilhaft ist es, wenn mehrere einstellbare Impedanzen oder abstimmbare Blindwiderstände zwischen dem HF-Generator und der Koppelimpedanz angeordnet sind, z. B. am Eingang und Ausgang eines Vierpols, der im Pfad des HF-Abstimmsignals liegt. Der Vierpol kann z.B. eine $\lambda/8$-Leitung sein. Damit lassen sich die Amplitude und Phase des HF-Abstimmsignals in einem genügend großen Bereich einstellen. Denn bei nur einer einzigen Referenzimpedanz muß diese Impedanz sowohl Wirk- wie auch Blindanteile besitzen, damit die Amplitude und Phase des HF-Abstimmsignals korrekt eingestellt werden kann. Ein einstellbarer Wirkanteil, beispielsweise ein HF-Potentiometer, ist aber HF-technisch immer eine kritische Komponente. Daher ist es von Vorteil, wenn mehrere einstellbare Blindwiderstände an verschiedenen Orten innerhalb der Empfängerschaltung eingesetzt werden, um die Amplitude und Phase des HF-Abstimmsignals in einem genügend großen Bereich einzustellen.

In einer bevorzugten Ausführungsform sind die Blindwiderstände kapazitive Trimmer, beispielsweise am Anfang und am Ende einer $\lambda/8$-Leitung. Der Vorteil dieser Anordnung liegt in der ausschließlichen Verwendung von kapazitiven Trimmern als einstellbaren Komponenten, die sich wesentlich besser und stabiler als HF-Potentiometer einstellen lassen.

In einer anderen bevorzugten Ausführungsform ist die Referenzimpedanz durch einen Attenuator von dem HF-Generator getrennt. Dadurch erreicht man, daß der HF-Generator sowie die dazugehörende Verbindungsleitung stets impedanzmäßig angepaßt sind, d.h. stets den korrekten Lastwiderstand sehen, und zwar unabhängig von der Abstimmung der Referenzimpedanz. In einer weiteren bevorzugten Ausführungsform ist die Referenzimpedanz als ein parallel zu einem Trimmer angeordneter variabler Widerstand ausgebildet. Der Trimmer berücksichtigt die noch vorhandenen parasitären Blindwiderstände innerhalb der Empfängerschaltung.

Bevorzugt sind im Pfad des NMR-Signals ein oder mehrere Schaltelemente angeordnet, wodurch vorteilhafterweise die Verbindung zur Impedanz der Empfangsspulenanordnung periodisch ein- und ausgeschaltet werden kann.

In einer weiteren Ausführungsform ist ein Gleichstrom über die Koppelimpedanz zuschaltbar. Über diesen Gleichstrom lassen sich eine oder mehrere Dioden im Pfad des NMR-Signals besonders einfach in den leitenden bzw. sperrenden Zustand versetzen.

Weitere Vorteile ergeben sich aus der Beschreibung und der beigefügten Zeichnung. Ebenso können die vorstehend genannten und die noch weiter aufgeführten Merkmale erfindungsgemäß jeweils einzeln für sich oder in beliebiger Kombination miteinander verwendet werden. Die erwähnten Ausführungsformen sind daher nicht als abschließende Aufzählung zu verstehen, sondern haben vielmehr beispielhaften Charakter.

Die Erfindung ist in der Zeichnung dargestellt und wird anhand von Ausführungsbeispielen näher erläutert. Es zeigen:

Fig. 1    eine Schaltungsanordnung für die halbautomatische Abstimmung einer NMR-Empfangsspule eines NMR-Spektrometers, dargestellt im Schaltungszustand für die Bestimmung des ersten Referenzsignals;

Fig. 2    die Schaltungsanordnung der Fig. 1 im Schaltungszustand für die Einstellung der Referenzimpedanz $Z_0$;

Fig. 3    die Schaltungsanordnung der Fig. 1 im Schaltungszustand für die Bestimmung des zweiten Referenzsignals;

Fig. 4    die Schaltungsanordnung der Fig. 3 im Schaltungszustand für die Abstimmung des Probenkopfes;

Fig. 5    eine vereinfacht dargestellte und dem Stand der Technik entsprechende Schaltungsanordnung zur Abstimmung der NMR-Empfangsspule im Probenkopf eines NMR-Spektrometers (dargestellt sind symbolische und nicht mechanische Schalter);

Fig. 6    eine der Fig. 5 entsprechende Schaltungsanordnung in ausführlicher Darstellung beim Stand der Technik;

Fig. 7    einen idealen Serieschalter;

Fig. 8    einen aus Seriediode und Drosselspule gebildeten Serieschalter;

Fig. 9    einen aus zwei $\lambda/4$-Leitungen und einer parallelen Diode gebildeten Serieschalter;

Fig. 10    eine Ausführungsform der erfindungsgemäßen automatischen Schaltungsvorrichtung zur Abstimmung der NMR-Empfangsspule im Probenkopf eines NMR-Spektrometers, wobei die Referenzimpedanz $Z_0$ getrennt vom Pfad des NMR-Signals angeordnet ist; und

Fig. 11    eine Schaltung zur Berechnung der Referenzimpedanz $Z_0$ bei getrennter Anordnung vom Pfad des NMR-Signals.

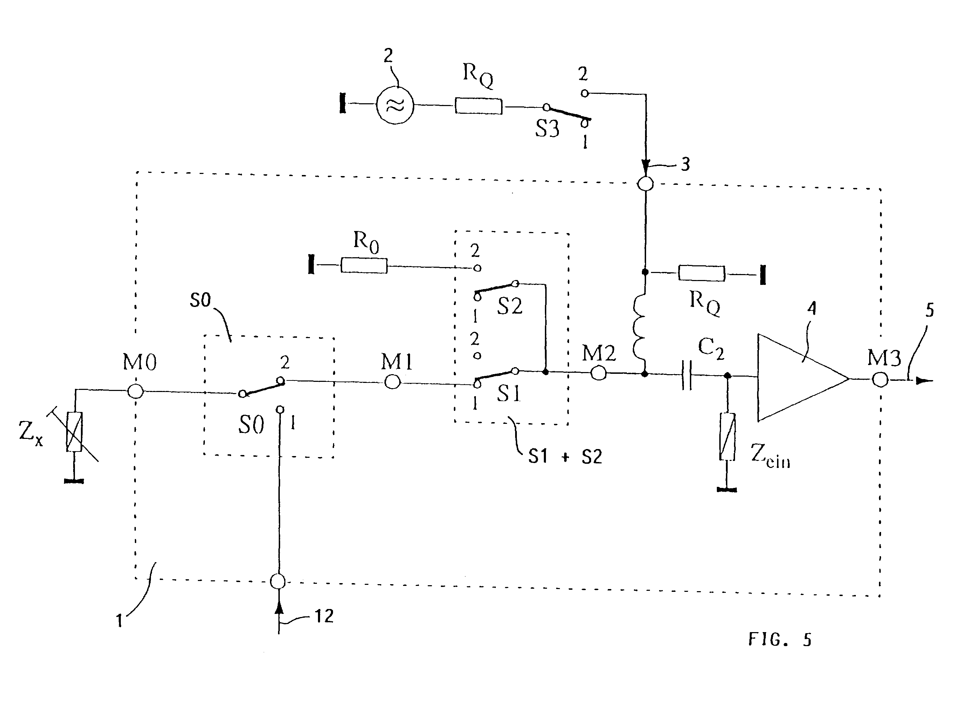

In Fig. 5 ist die prinzipielle Funktionsweise einer Empfängerschaltung 1 zum Abstimmen der Impedanz $Z_x$ der Empfangsspulenanordnung eines NMR-Spektrometers (nicht gezeigt) beim Stand der Technik dargestellt. Im normalen Betriebszustand, in welchem ein HF-Anregungspuls 12 zur Anregung der Probenkopfspule eingespeist wird, befinden sich die Schalter S1, S2 und S3 in der Position 1, d.h., sowohl der Referenzwiderstand $R_0$ wie auch die HF-Abstimmquelle, z. B. ein HF-Generator 2, sind ausgeschaltet. Zuerst wird der Umschalter S0 auf Position 1 gebracht und der HF-Anregungspuls 12 zur NMR-Anregung eingespeist. Anschließend wird der Umschalter S0 auf Position 2 gestellt, so daß die Impedanz $Z_x$ der Empfangsspulenanordnung mit dem Vorverstärker 4 verbunden und das Empfangssystem für die Aufnahme des so am Ort M3 verstärkten HF-Signals 5 bereit ist.

Die Verwendung von mechanischen Relais für die Schalter S1 und S2 ist aus mehreren Gründen von Nachteil: zum einen wegen der mangelhaften Funktionstüchtigkeit mechanischer Kontaktsysteme, aber auch deshalb, weil diese Relais im Streufeld des NMR-Magneten arbeiten müßten und daher nicht zuverlässig funktionieren könnten. Daher werden Dioden, vorzugsweise pin-Dioden, verwendet.

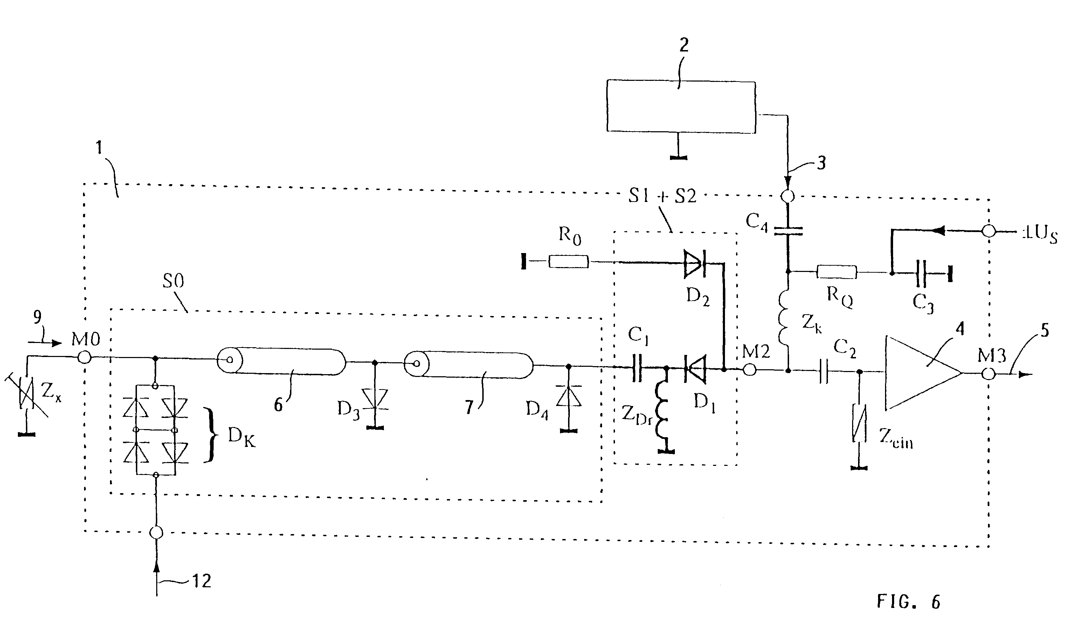

Eine mit pin-Dioden beim Stand der Technik realisierte Schaltung nach Fig. 5 ist in Fig. 6 dargestellt. Der Umschalter S0 besteht unter anderem aus einer Diodenkette $D_K$, die durch den HF-Sendepuls 12 direkt in den leitenden Zustand gebracht wird und dadurch den HF-Sendepuls 12 an den Punkt M0 leitet. Die große Amplitude (über 100 V) dieses Anregungsimpulses schaltet die pin-Diode $D_3$ durch, so daß eine erste $\lambda/4$ -Leitung 6 einseitig kurzgeschlossen wird und am Eingang M0 des NMR-Spektrometers (nicht gezeigt) eine hochohmige Impedanz darstellt. Der HF-Sendepuls 12 wird deshalb den Weg in den Probenkopf bzw. in die Impedanz $Z_x$ der Empfangsspulenanordnung wählen und nur sehr wenig Energie (ca. 2%) in Richtung Vorverstärker 4 übertragen. Diese Restenergie wird mit einer zweiten $\lambda/4$-Leitung 7 und der ebenfalls durchgeschalteten pin-Diode $D_4$ noch zusätzlich gedämpft, um den empfindlichen Eingang des Vorverstärkers 4 wirksam zu schützen. Die Dioden $D_3$ und $D_4$ sind gegenseitig mit der Masse verbunden, um in der Einschaltphase des HF-Sendepulses 12 die Dioden $D_3$ und $D_4$ schneller in den leitenden Zustand zu bringen. Startet der HF-Sendepuls 12 mit einer positiven Flanke, dann wird diese an der Diode $D_3$ gleichgerichtet, und der Gleichstrom kann sich über Diode $D_4$ kurzschließen und diese ebenfalls in den leitenden Zustand bringen. Bei einer negativen Flanke wirkt die Diode $D_4$ als Gleichrichter, und $D_3$ wird durch den Gleichstrom in den leitenden Zustand gebracht. Nach einer kurzen Zeit verschwindet dieser Gleichrichtungseffekt, und die pin-Dioden $D_3$ und $D_4$ wirken HF-mäßig als niederohmige Widerstände. Dieses Verhalten ist typisch für pin-Dioden.

Es sollte hier deutlich beachtet werden, daß

die beiden $\lambda/4$-Leitungen 6, 7 und die Dioden $D_3$ und $D_4$ alleine der Einspeisung des hochenergetischen HF-Sendepulses 12 und dem Schutz des Vorverstärkers 4 dienen. Bei den weiter unten beschriebenen erfindungsgemäßen neuen Schaltungen erfüllen diese Komponenten eine Doppelfunktion, was große Vorteile hat.

Die Kapazitäten $C_1$, $C_3$ und $C_4$ und die Drossel $Z_{Dr}$ sind für die Ein- und Ausschaltung der pin-Dioden $D_1$ und $D_2$ notwendig. Sie dienen dazu, den durch die Schaltspannung $U_S$ erzeugten Gleichstrom in die gewünschten Bahnen zu leiten. Für ein HF-Abstimmsignal 3 bedeuten die drei Kapazitäten näherungsweise Kurzschlüsse und die Drossel $Z_{Dr}$ eine hochohmige Impedanz, bestehend aus einer kleinen, verlustbehafteten Kapazität.

Wenn $U_S$ positiv ist, wird die Diode $D_2$ gesperrt und die Diode $D_1$ durchgeschaltet. Dadurch wird der Probenkopf bzw. dessen Impedanz $Z_x$ über die Diode $D_1$ mit einem Referenzpunkt M2 verbunden. Wenn $U_S$ negativ ist, wird $D_1$ gesperrt und $D_2$ durchgeschaltet, wodurch der Referenzwiderstand $R_0$ über $D_2$ mit dem Referenzpunkt M2 verbunden wird.

Nachdem der HF-Anregungspuls 12 wieder ausgeschaltet ist, sperren die Diodenkette $D_K$ und die Dioden $D_3$ und $D_4$ wieder. Die beiden $\lambda/4$-Leitungen 6, 7 benehmen sich dann wieder wie normale HF-Leitungen mit einem Wellenwiderstand $R_W = R_0 = 50\,\Omega$ und leiten das ankommende NMR-Signal mit geringer Dämpfung weiter. Letzteres gelangt über die Diode $D_1$ an den Vorverstärker 4, wird dort vorverstärkt, im anschließenden Empfänger auf tiefere Frequenzen hinuntergemischt, verstärkt und in Quadratur phasendetektiert, digitalisiert und im Rechner zum gewünschten Signal verarbeitet.

Im Betriebszustand "Probenkopfabstimmung" wird der HF-Generator über den Schalter S3 angeschlossen, und die Abstimmung erfolgt in drei Schritten:

Schritt 1: Zuschaltung des Referenzwiderstandes $R_0$

Beim Stand der Technik geht man davon aus, daß die Impedanz $Z_x$ der Empfangsspulenanordnung am Eingang M0 durch den Referenzwiderstand $R_0$ ersetzt wird. Der Referenzwiderstand $R_0$ stellt den gewünschten reellen Widerstand dar, den die Impedanz $Z_x$ der Empfangsspulenanordnung annehmen sollte. Da aber ein Widerstand $R_0$ am Eingang M0 eins zu eins über die beiden $\lambda/4$-Leitungen 6, 7 zum Punkt M2 transformiert wird (Grund: Wellenwiderstand $R_W$ der Leitungen ist gleich $R_0$), genügt es, den Referenzwiderstand $R_0$ über den Schalter S2 direkt mit dem Referenzpunkt M2 zu verbinden, und den Referenzpunkt M2 mit dem Schalter S1 vom Eingang M0 zu trennen. Die beiden Schalter S1 und S2 werden auf Position 2 gestellt

Es wäre zwar theoretisch möglich, die beiden Schalter S1 und S2 direkt am Punkt M0 zu plazieren, um auf diese Weise unabhängig von den $\lambda/4$-Leitungen 6, 7 zu werden. Praktisch ist dies aber schlecht möglich, da während der Dauer des HF-Sendepulses 12 sehr hohe HF-Spannungen an diesem Punkt herrschen. Diese würden die beiden Dioden $D_1$ und $D_2$, mit denen die Schalter S1 und S2 realisiert werden, vollständig durchschalten und möglicherweise sogar spannungsbedingt zerstören.

Schritt 2: Erzeugung des Referenzsignals

Der HF-Generator 2 wird aktiviert und liefert über eine hochohmige Koppelimpedanz $Z_k$ ein HF-Abstimmsignal 3 mit einer vorzugsweise linear sich ändernden Frequenz an den Referenzpunkt M2 am Eingang des Vorverstärkers 4. Der Frequenzbereich dieses Signals sollte um die gewünschte Betriebsfrequenz zentriert sein und ein mehrfaches der Bandbreite des Empfangsschwingkreises im Probenkopf betragen.

Dieses HF-Abstimmsignal 3 erzeugt am Referenzpunkt M2 ein Signal, das stark vom Referenzwiderstand $R_0$ abhängig ist und das über den Vorverstärker 4 und Empfänger in einen Rechner gelangt, wo es gespeichert wird. Das gespeicherte Signal ist ein vektorielles Signal in der komplexen Ebene und besitzt deshalb einen Real- und einen Imaginäranteil, welche durch die beiden Ausgänge der Quadratur-Detektion gegeben sind. Beide Anteile stellen frequenzabhängige Funktionskurven dar und definieren das Referenzsignal, das für den Abstimmprozeß benötigt wird.

Schritt 3: Erzeugung des Differenzsignals

Schalter S1 und S2 werden wieder auf Position 1 gebracht. Damit wird die Impedanz $Z_x$ der Empfangsspulenanordnung über die $\lambda/4$-Leitungen 6, 7 an den Referenzpunkt M2 geschaltet, d.h. an den selben Punkt, an dem vorher der Referenzwiderstand $R_0$ angeschlossen war. Das durch das HF-Abstimmsignal 3 des HF-Generators 2 am Referenzpunkt M2 erzeugte neue Signal wird wie beim Schritt 2 weiterverarbeitet und im Rechner gespeichert. Anschließend wird dieses Signal vektoriell vom Referenzsignal abgezogen und daraus der Absolutwert gebildet. Auf diese Weise entsteht das Differenzsignal, das auf dem Bildschirm angezeigt wird.

Falls $Z_x$ im gemessenen Frequenzbereich identisch mit $R_0$ wäre, würde das Differenzsignal überall Null betragen. Dieser Fall tritt aber nicht auf, da die Impedanz $Z_x$ der Empfangsspulenanordnung durch den frequenzabhängigen Empfangsschwingkreis bestimmt wird. Das Differenzsignal hat deshalb die Form einer vertikal gespiegelten Resonanzkurve, wobei das Minimum den einzigen Punkt darstellt, wo $Z_x$ den Wert $R_0$ annehmen, d.h. wo eine exakte Impedanzanpassung stattfinden kann.

Die Erzeugung des Differenzsignals wird periodisch und automatisch wiederholt, damit die Änderungen, die durch den Abstimmprozeß verursacht werden, beobachtet werden können. Der Abstimmprozeß erfolgt normalerweise manuell durch Veränderung der Resonanz- und der Koppelkapazität des Empfangsschwingkreises. Bei einem nicht genau abgestimmten Probenkopf erscheint das Minimum des Differenzsignals außerhalb der gewünschten Betriebsfrequenz und beträgt nicht Null. Erst wenn das Minimum bei der gewünschten Betriebsfrequenz liegt und Null beträgt, ist der Abstimmvorgang abgeschlossen.

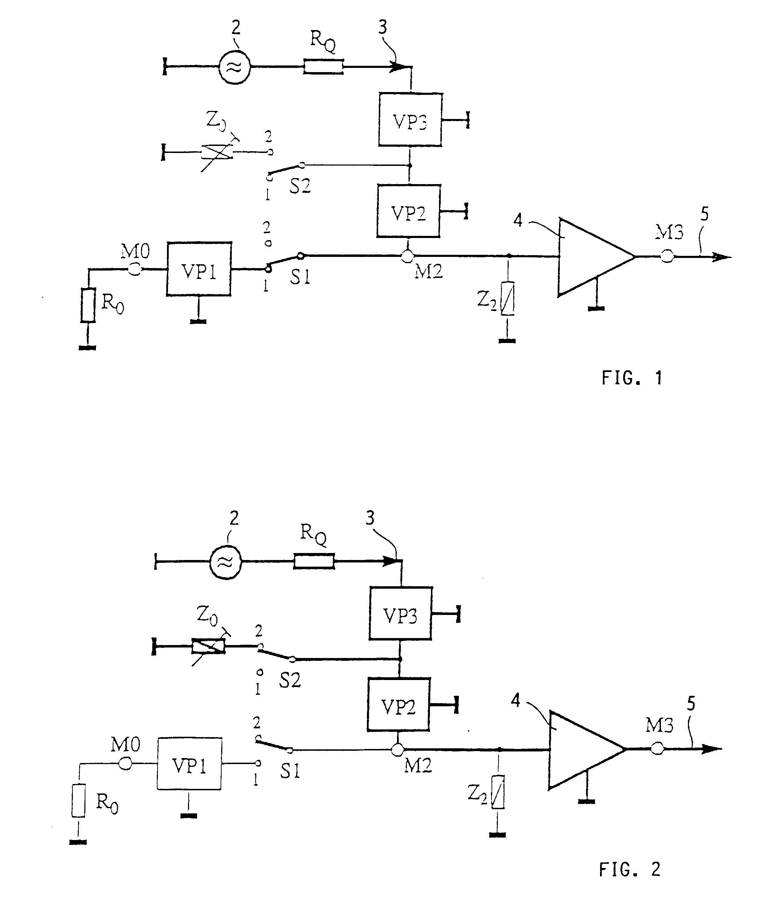

In den Fign. 1 bis 4 sind die einzelnen Schritte des erfindungsgemäßen Verfahrens dargestellt. VP1, VP2 und VP3 sind beliebige Vierpole, die normalerweise aus passiven Schaltelementen aufgebaut sind, aber auch aktive Schaltelemente enthalten können. VP1 ist ein beliebiger Vierpol, der zeigen soll, daß beim erfindungsgemäßen Verfahren die beiden Punkte M0 und M2 nicht mehr über den Schalter S1 direkt miteinander verbunden sein müssen. VP1 kann z.B. ein Impedanztransformator sein mit einem komplexen Übersetzungsverhältnis.

VP2 kann eine hochohmige Koppelimpedanz $Z_K$ enthalten (z.B. eine Drossel), um den Pfad 9 des NMR-Signals von $Z_0$ zu trennen, ist aber auch als beliebiger Vierpol zu betrachten. VP3 kann einen Attenuator 8 enthalten, um $Z_0$ vom HF-Generator 2 zu trennen, sowie auch andere Schaltelemente.

Die neuartige Referenzerzeugung verwendet nicht mehr einen Referenzwiderstand $R_0$ von 50Ω im Pfad 9 des NMR-Signals, sondern eine Referenzimpedanz $Z_0$ (oder mehrere an verschiedenen Stellen) getrennt vom Pfad 9 des NMR-Signals. $Z_0$ läßt sich mathematisch berechnen (siehe unten), wobei nur ein ungefährer Wert resultieren kann, da die rechnerisch erforderlichen Parameter nicht genau bekannt sind. Um $Z_0$ genau auf den korrekten Wert einzustellen, ist deshalb noch ein manueller Referenzabgleich notwendig. Dieser braucht jedoch (wenn überhaupt) nur in größeren Zeitabständen wiederholt zu werden (Wochen, Monate, Jahre), da nur die Alterungseffekte der Schaltelemente eine Veränderung des korrekten Abgleichs verursachen können. Als Bezugsgröße wird ein genauer und stabiler Widerstand benützt (Referenzwiderstand $R_0$), der am gewünschten Abstimmungsort angebracht wird.

Der Referenzabgleich ist in den Fign. 1 und 2 dargestellt. Am Eingang $M_0$ ist der Referenzwiderstand $R_0$ angeschlossen.

In einem ersten Schritt (Schalter S1 und S2 auf Position 1) wird $R_0$ über VP1 und Schalter S1 mit dem Referenzpunkt M2 verbunden und $Z_0$ mit Hilfe des Schalters S2 abgetrennt. (Fig. 1). Dies entspricht dem normalen Betriebszustand, ausgenommen daß am Eingang M0 der gewünschte Widerstand $R_0$ anstelle der tatsächlichen Impedanz $Z_x$ der Empfangsspulenanordnung liegt und der HF-Generator 2 eingeschaltet ist. Das HF-Abstimmsignal 3, dessen Frequenz periodisch zwischen zwei Werten linear variiert wird, erzeugt am Referenzpunkt M2 ein Signal, das über den Vorverstärker 4, Empfänger, Quadraturdetektor und AD-Wandler (nicht gezeigt) in den Rechner gelangt. Eine ganze Periode dieses Signals wird vektoriell gespeichert und als erstes Referenzsignal bezeichnet.

In einem zweiten Schritt (Schalter S1 und S2 auf Position 2) wird $R_0$ mit Hilfe des Schalters S1 vom Referenzpunkt M2 getrennt und dafür die Referenzimpedanz $Z_0$ über den Schalter S2 zugeschaltet (Fig. 2). Die nächste Periode des HF-Abstimmsignals 3 erzeugt am Referenzpunkt M2 ein neues Signal, das analog zum ersten Schritt gemessen und vektoriell gespeichert wird. Dieses Signal, im folgenden als zweites Referenzsignal bezeichnet, wird vektoriell vom Referenzsignal 1 abgezogen und daraus der Absolutwert gebildet. Damit erhält man das Differenzsignal A, das auf dem Bildschirm als y-Signal angezeigt wird. Das x-Signal ist durch die Frequenzvariation definiert.

Diese beiden Schritte werden periodisch wiederholt, so daß während der Abstimmung der Referenzimpedanz $Z_0$ ein veränderliches Bild auf dem Bildschirm erscheint. $Z_0$ wird nun solange variiert, bis das Differenzsignal A auf dem Bildschirm im gewünschten Frequenzbereich möglichst genau Null ist. Damit ist das zweite Referenzsignal praktisch identisch dem ersten Referenzsignal, und das bedeutet, daß anstelle des ersten Referenzsignals das zweite Referenzsignal benutzt werden kann. Letzteres besitzt den großen Vorteil, daß es mit einer Schaltanordnung gemessen werden kann, die keine merkliche Verschlechterung des S/N-Verhältnisses verursacht.

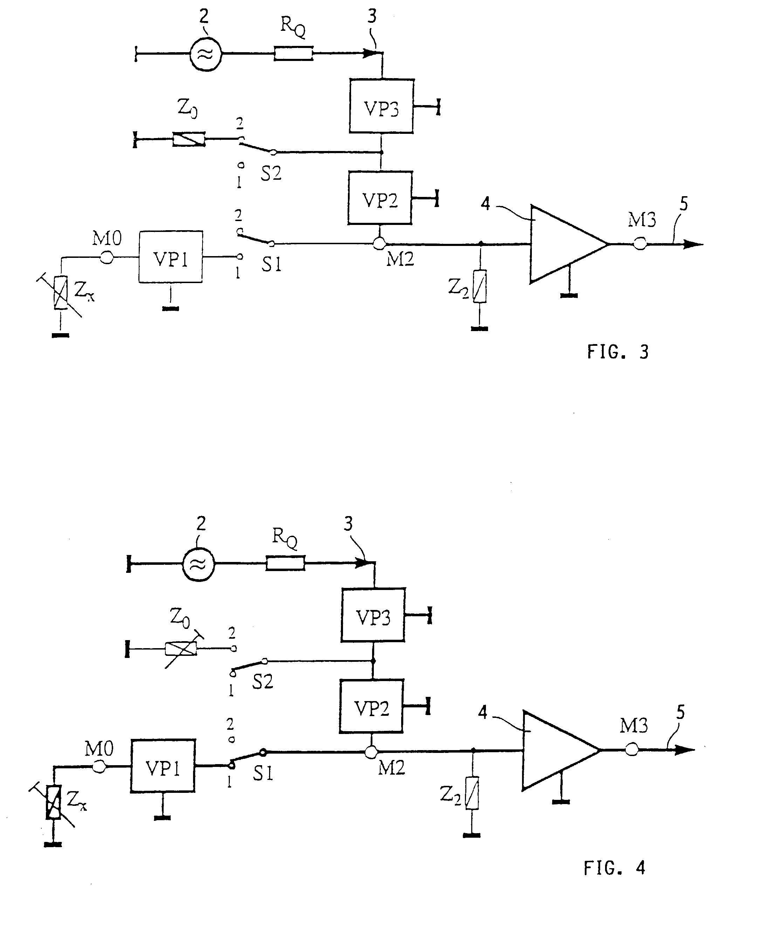

Zur Abstimmung des Probenkopfes muß die Impedanz $Z_x$ der Empfangsspulenanordnung am Eingang M0 liegen. Der Abstimmungsvorgang ist in den Fign. 3 und 4 dargestellt. Es werden ebenfalls zwei Schritte benötigt.

In einem ersten Schritt (Schalter S1 und S2 auf Position 2) wird das zweite Referenzsignal während einer Periode der linearen Frequenzvariation gemessen und vektoriell gespeichert (Fig. 3).

In einem zweiten Schritt (Schalter S1 und S2 auf Position 1) wird das von der Impedanz $Z_x$ der Empfangsspulenanordnung abhängige Signal am Referenzpunkt M2 während der nächsten Periode der linearen Frequenzvariation gemessen (Fig. 4), vektoriell gespeichert, vektoriell vom zweiten Referenzsignal abgezogen und davon der Absolutwert gebildet. Dieses Signal wird als Differenzsignal B bezeichnet. Es wird auf dem Bildschirm als y-Signal angezeigt. Das x-Signal ist wiederum durch die Frequenzvariation definiert.

Die beiden Schritte werden periodisch wiederholt, so daß während der Abstimmung der Impedanz $Z_x$ der Empfangsspulenanordnung ein veränderliches Bild auf dem Bildschirm erscheint, das die Form einer vertikal gespiegelten Resonanzkurve besitzt. Obwohl beim zweiten Referenzsignal keine offensichtlichen Änderungen stattzufinden scheinen, darf die Wiederholung von Schritt 1 nicht weggelassen werden. Es muß nämlich mit langsamen Schwankungen des Signalpegels des HF-Generators 2 während der Dauer des Abstimmvorganges gerechnet werden, und diese verändern das zweite Referenzsignal.

Der Abstimmungsvorgang ist dann abgeschlossen, wenn das Minimum der Kurve ungefähr Null ist und am gewünschten Frequenzpunkt liegt.

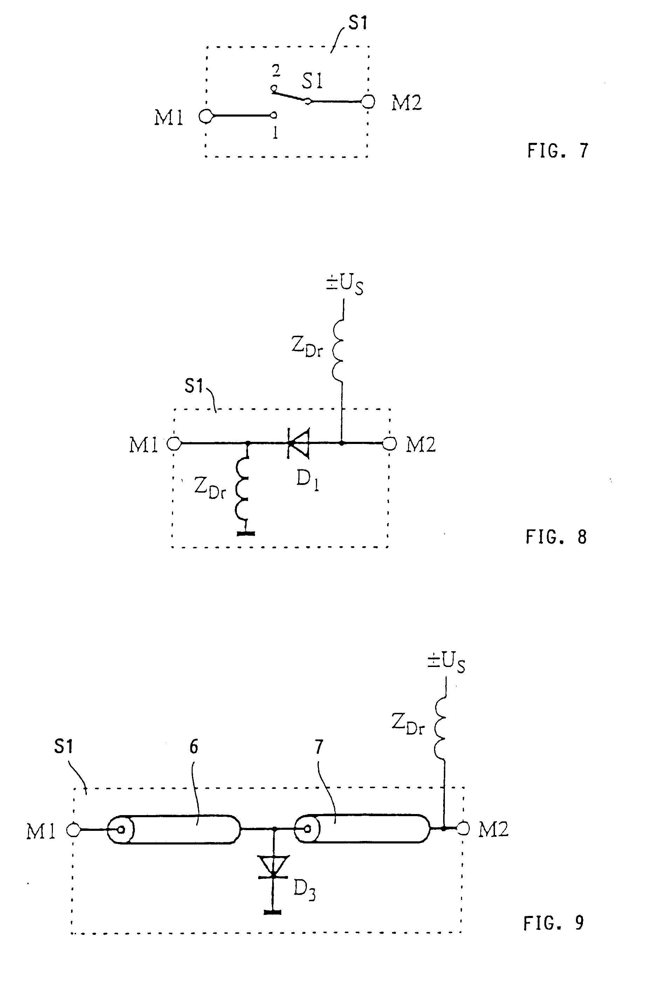

Damit das zweite Referenzsignal periodisch neu bestimmt werden kann, muß die Verbindung zum Probenkopf bzw. zur Impedanz $Z_x$ der Empfangsspulenanordnung ebenfalls periodisch ein- und ausgeschaltet werden. Ein Serieschalter beispielsweise in Form des in Fig. 7 gezeigten idealen Serieschalters S1 im Pfad 9 des NMR-Signals ist deshalb unumgänglich.

Die Lösung, eine in Serie geschaltete pin-Diode $D_1$ als Serieschalter zu benützen (Fig. 8), ist bekannt und führt, wie schon erwähnt, zu einer Verschlechterung des S/N-Verhältnisses.

In Fig. 9 ist ein verlustarmer Serieschalter dargestellt, welcher im geschlossenen Zustand mit einer gesperrten Diode $D_3$ auskommt. Wenn $U_S$ negativ ist, dann sperrt die pin-Diode $D_3$, und der Punkt M1 ist über die beiden $\lambda/4$-Leitungen 6, 7 mit Referenzpunkt M2 direkt und verlustarm verbunden. Dies entspricht dem geschlossenen Zustand des Serieschalters. Dieser Zustand herrscht beim normalen Betriebszustand des Empfangssystems, und gerade hier sollten kleine Signalverluste realisiert werden. Eine sperrende Diode ist deshalb besser als eine leitende, weil erstere etwas kleinere Verluste verursacht.

Wenn $U_S$ positiv ist, leitet die pin-Diode $D_3$ und stellte einen Kurzschluß auf Masse von ca. $1\Omega$ dar. Dieser Widerstand wird durch die beiden $\lambda/4$-Leitungen 6, 7 hinauftransformiert und erscheint an den Punkten M1 und M2 als hochohmiger Widerstand von ca. $2,5\,k\Omega$, der gegenüber $50\Omega$ nicht stark ins Gewicht fällt. Die Impedanz, die man von beiden Seiten in den Schalter hinein sieht, ist dennoch hochohmig, was dem geöffneten Zustand des Serieschalters entspricht.

Diese Art von Serieschalter hat die Eigenschaft, daß die Schaltdiode im geschlossenen Zustand sperrt und im geöffneten Zustand leitet. Dies ist gerade ein umgekehrtes Verhalten, verglichen mit der bekannten Anordnung (Fig. 8), wo die Schaltdiode in Serie zum Pfad 9 des NMR-Signals liegt.

Vergleicht man den beschriebenen Serieschalter (Fig. 9) mit dem Umschalter S0 in Fig. 6, so sind gewisse Ähnlichkeiten erkennbar. Der Umschalter S0 besitzt bereits alle für den Serieschalter S1 notwendigen HF-Komponenten, allerdings auch noch zusätzlich die Diodenkette Dk und die Diode $D_4$, die aber die Funktionsweise von S1 nicht stören. Es ist somit möglich, den Serieschalter S1 ohne Einführung zusätzlicher Komponenten zu realisieren, und dies erspart immerhin eine Diode ($D_1$), eine Drossel ($Z_{Dr}$) und eine Kapazität ($C_1$), verglichen mit dem in Fig. 6 gezeigten Stand der Technik.

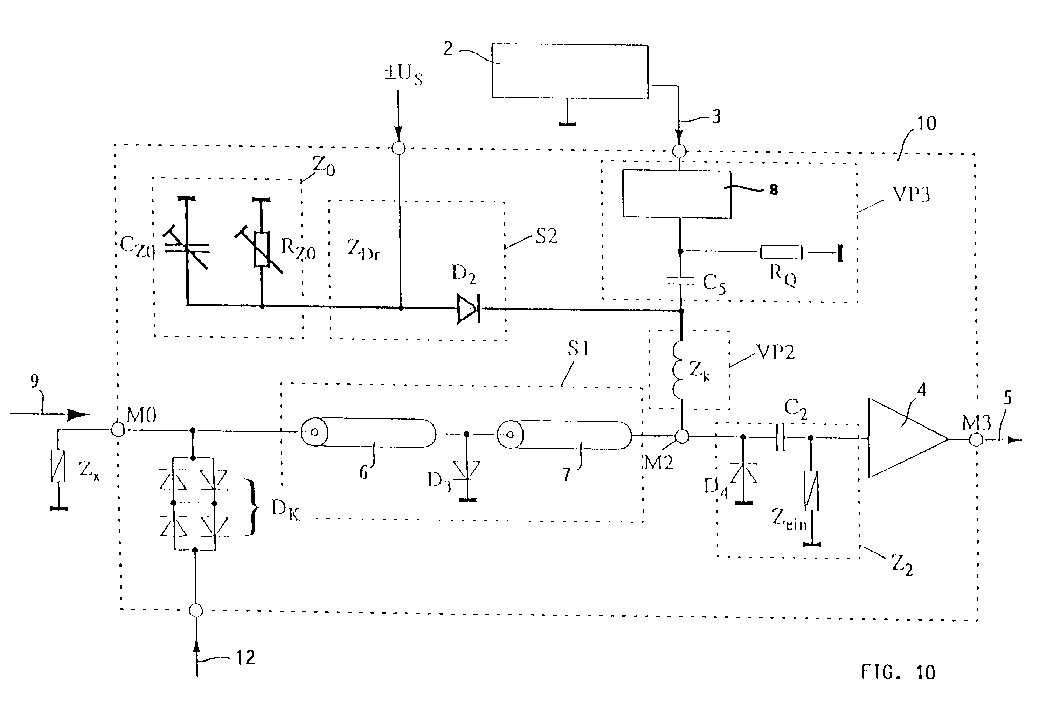

Fig. 10 zeigt eine erste erfindungsgemäße Schaltungsanordnung, bei der die Referenzimpedanz $Z_0$ durch die hochohmige Koppelimpedanz $Z_k$ vom Pfad 9 des NMR-Signals abgetrennt ist. Die gestrichelt umrandeten Bereiche beziehen sich auf die in den Fign. 5 und 6 verwendeten Funktionsblöcke.

Der Vierpol VP1 erscheint in Fig. 10 nicht. VP1 kann beispielsweise ein Impedanztransformator bedeuten, mit dem im normalen Betriebszustand eine zusätzliche Impedanztransformation vom Punkt M0 zum Referenzpunkt M2 erreicht wird. Da aber diese Transformation nur in ganz speziellen Fällen eingesetzt wird, ist sie in Fig. 10 weggelassen.

Die Schaltung in Fig. 10 benützt die Variante mit nur einer abstimmbaren Referenzimpedanz $Z_0$. Diese kann durch einen variablen Widerstand $R_{ZO}$ von ca. $100\Omega$ parallel zu einem Trimmer $C_{ZO}$ von ca. 15 pF realisiert werden. $C_{ZO}$ berücksichtigt hauptsächlich die noch vorhandenen parasitären Blindwiderstände innerhalb der Schaltung.

Der Attenuator 8 im Vierpol VP3 trennt den HF-Generator 2 von der Referenzimpedanz $Z_0$. Dadurch erreicht man, daß der HF-Generator 2 sowie die dazugehörende Verbindungsleitung stets impedanzmäßig angepaßt sind, d.h., stets den korrekten Lastwiderstand sehen, und zwar unabhängig von der Abstimmung von $Z_0$.

Die Längen der beiden $\lambda/4$-Leitungen 6, 7 des Umschalters S1 müssen nicht genau eine Länge von $\lambda/4$ besitzen. Insbesondere kann die zweite $\lambda/4$-Leitung 7 Abweichungen von bis über $\pm 40\%$ aufweisen und trotzdem mit Hilfe der Diode $D_4$ den Restanteil des HF-Sendepulses 12 noch genügend unterdrücken. Die Einhaltung der Länge bei der ersten $\lambda/4$-Leitung 6 ist jedoch kritischer. Hier führt eine ungenaue Länge zu einer Fehlanpassung und Leistungsreflexion des HF-Sendepulses 12 am Punkt M0, die nicht zu groß sein darf. Aber auch hier sind Toleranzen in der Länge von $\pm 5\%$ durchaus erlaubt.

Die Längen der $\lambda/4$-Leitungen 6, 7 des HF-Serieschalters in Fig. 9 müssen ebenfalls nicht genau $\lambda/4$ sein. Abweichungen von bis über $\pm 40\%$ sind auch hier tolerierbar, denn sie verursachen in erster Linie nur (kapazitive sowie induktive) Blindbelastungen am Ein- und Ausgang des Schalters.

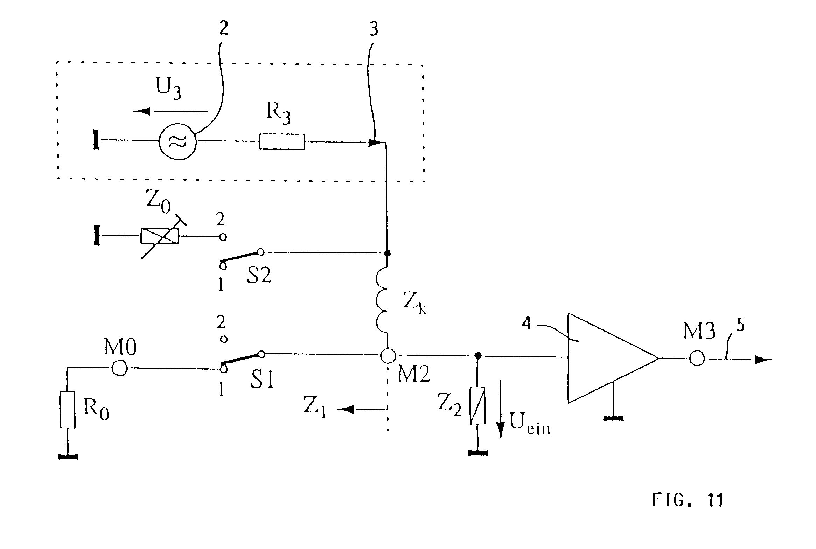

Mit Hilfe von Fig. 11 läßt sich die Referenzimpedanz $Z_0$ folgendermaßen berechnen, wenn diese getrennt vom Pfad des NMR-Signals angeordnet ist. Unter der Annahme, daß die Impedanz $Z_k$ viel größer als alle anderen Impedanzen sind, ergibt sich für ($U_{ein}$): im Fall 1, wenn S1 und S2 in Position 2 sind und $Z_1 = Z_1\infty$ ist:

$$(U_{ein})_1 = U_3 \cdot \frac{Z_0}{R_3 + Z_0} \frac{1}{Z_k} \frac{Z_2 Z_1 \infty}{Z_2 + Z_1 \infty};$$

im Fall 2, wenn S1 und S2 in Position 1 sind:

$$(U_{ein})_2 = U_3 \cdot \frac{1}{Z_k} \cdot \frac{Z_2 R_0}{Z_2 + R_0}.$$

Damit $U_{ein}$ in beiden Fällen identisch ist, muß $(U_{ein})_1 = (U_{ein})_2$ gelten, d.h.:

$$U_3 \cdot \frac{Z_0}{R_3 + Z_0} \cdot \frac{1}{Z_k} \cdot \frac{Z_2 Z_1 \infty}{Z_2 + Z_1 \infty} = U_3 \cdot \frac{1}{Z_k} \cdot \frac{Z_2 R_0}{Z_2 + R_0}$$

$$\frac{Z_0}{R_3 + Z_0} \cdot \frac{Z_1 \infty}{Z_2 + Z_1 \infty} = \frac{R_0}{Z_2 + R_0}$$

$$Z_0 = \frac{R_3 R_0}{Z_2} \cdot \frac{1 + (Z_2 / Z_1 \infty)}{1 - (R_0 / Z_1 \infty)} \approx \frac{R_3 R_0}{Z_2}$$

Werden als numerisches Beispiel

$R_3 = R_Q/2 = 25\ \Omega$
$R_0 = 50\ \Omega$
$Z2 = 50\ \Omega$ (=Eingangsimpedanz des Vorverstärkers 4)
$Z_1 \infty = 2500\ \Omega$

in Gleichung 3 eingesetzt, ergibt sich für $Z_0$
$Z_0 = 26,02\ \Omega$.

## Patentansprüche

1. Verfahren zum Abstimmen der Impedanz ($Z_x$) einer Empfangsspulenanordnung im Probenkopf eines NMR-Spektrometers mit einer Empfängerschaltung für ein NMR-Signal, bei welchem Verfahren mittels eines HF-Abstimmsignals (3) die Impedanz ($Z_x$) der Empfangsspulenanordnung über ein mit einem reellen Referenzwiderstand ($R_0$) erzeugtes erstes Referenzsignal an einem Referenzpunkt (M2) innerhalb der Empfängerschaltung abgestimmt wird,
dadurch gekennzeichnet,
daß eine Referenzimpedanz ($Z_0$), die durch eine oder mehrere Impedanzen vom Pfad (9) des NMR-Signals getrennt ist, so abgeglichen wird, daß ein dem ersten Referenzsignal am Referenzpunkt (M2) entsprechendes zweites Referenzsignal am Referenzpunkt (M2) entsteht, und daß anschließend die Impedanz ($Z_x$) der Empfangsspulenanordnung auf das zweite Referenzsignal am Referenzpunkt (M2) abgestimmt wird.

2. Verfahren nach Anspruch 1, dadurch gekennzeichnet, daß das erste Referenzsignal mindestens einmal bestimmt und beim Abgleichvorgang der Referenzimpedanz ($Z_0$) das zweite Referenzsignal periodisch erzeugt wird.

3. Verfahren nach Anspruch 1 oder 2, dadurch gekennzeichnet, daß das zweite Referenzsignal mindestens einmal ermittelt und beim Abstimmvorgang der Impedanz ($Z_x$) der Empfangsspulenanordnung das mit Hilfe der Impedanz ($Z_x$) der Empfangsspulenanordnung ermittelte Signal periodisch erzeugt wird.

4. Verfahren nach einem der vorhergehenden Ansprüche, dadurch gekennzeichnet, daß das zweite Referenzsignal am Anfang des Abstimmvorgangs der Impedanz ($Z_x$) der Empfangsspulenanordnung mindestens einmal neu bestimmt wird.

5. Schaltungsvorrichtung zur Durchführung des Verfahrens nach einem der Ansprüche 1 bis 4, mit einem HF-Generator (2) zur Erzeugung des HF-Abstimmsignals (3) und mit Schaltelementen im Pfad (9) des NMR-Signals, dadurch gekennzeichnet, daß die Referenzimpedanz ($Z_0$) an einem Ort innerhalb der Empfängerschaltung (10; 11) angeordnet ist, der durch eine oder mehrere Impedanzen vom Pfad (9) des NMR-Signals getrennt ist.

6. Schaltungsvorrichtung nach Anspruch 5, dadurch gekennzeichnet, daß mehrere einstellbare Impedanzen oder abstimmbare Blindwiderstände zwischen dem HF-Generator (2) und einer Koppelimpedanz ($Z_k$), die die Referenzimpedanz ($Z_0$) vom Pfad des NMR-Signals trennt, angeordnet sind.

7. Schaltungsvorrichtung nach Anspruch 6, dadurch gekennzeichnet, daß die Blindwiderstände kapazitive Trimmer sind.

8. Schaltungsvorrichtung nach einem der Ansprüche 5 bis 7, dadurch gekennzeichnet, daß die Referenzimpedanz ($Z_0$) durch einen Attenuator (8) von dem HF-Generator (2) getrennt ist.

9. Schaltungsanordnung nach einem der Ansprüche 5 bis 8, dadurch gekennzeichnet, daß die Referenzimpedanz ($Z_0$) als ein parallel zu einem Trimmer ($C_{Z0}$) variabler Widerstand ($R_{Z0}$) ausgebildet ist.

10. Schaltungsvorrichtung nach einem der Ansprüche 5 bis 9, dadurch gekennzeichnet, daß im Pfad (9) des NMR-Signals ein oder mehrere Schaltelemente (S0, S1, S2) angeordnet sind.

11. Schaltungsvorrichtung nach Anspruch 9, dadurch gekennzeichnet, daß ein Gleichstrom aus einer Spannungsquelle ($U_S$) über die Koppelimpedanz ($Z_k$) zuschaltbar ist.

## Claims

1. Method of matching the impedance ($Z_x$) of a receiver coil arrangement in the probe head of an NMR spectrometer with a receiver circuit for an NMR signal, in which method the impedance ($Z_x$) of the receiver coil arrangement is matched by means of an RF matching signal (3) via a first reference signal generated with a real reference resistance ($R_0$) at a reference point (M2) within the receiver circuit, characterized in that
a reference impedance ($Z_0$), which is separated by one or several impedances from the path (9) of the NMR signal, is matched such that a second reference signal corresponding to the first reference signal at the reference point (M2) is generated at the reference point (M2), and that subsequently, the impedance ($Z_x$) of the receiver coil arrangement is matched with the second reference signal at the reference point (M2).

2. Method according to claim 1, characterized int hat the first reference signal is determined at least once and the second reference signal is periodically generated during the matching process of the reference impedance ($Z_0$).

3. Method according to claim 1 or 2, characterized in that the second reference signal is determined at least once and the signal determined by means of the impedance ($Z_x$) of the receiver coil arrangement is generated periodically during the matching process of the impedance ($Z_x$) of the receiver coil arrangement.

4. Method according to any of the preceding claims, characterized in that the second reference signal is determined anew at least once at the start of the matching process of the impedance ($Z_x$) of the receiver coil arrangement.

5. Circuit arrangement for carrying out the method according to any of claims 1 through 4, comprising an RF generator (2) for the generation of the RF matching signal (3) and comprising circuit elements in the path (9) of the NMR signal, characterized in that the reference impedance ($Z_0$) is arranged at a location within the receiver circuit (10;11) which is separated by one or more impedances from the path (9) of the NMR signal.

6. Circuit arrangement according to claim 5, characterized in that several adjustable impedances or matchable blind resistances are arranged between the RF generator (2) and a coupling impedance ($Z_k$) which separates the reference impedance ($Z_0$) from the path of the NMR signal.

7. Circuit arrangement according to claim 6, characterized in that the blind resistances are capacitive trimmers.

8. Circuit arrangement according to any of the claims 5 to 7, characterized in that the reference impedance ($Z_0$) is separated from the RF generator by an attenuator (8).

9. Circuit arrangement according to any of the claims 5 to 8, characterized in that the reference impedance ($Z_0$) is formed as a variable resistance ($R_{Z0}$) parallel to a trimmer ($C_{Z0}$).

10. Circuit arrangement according to any of claims 5 to 9, characterized in that in the path (9) of the NMR signal one or more circuit elements (S0,S1,S2) are arranged.

11. Circuit arrangement according to claim 9, characterized in that a direct current from a voltage source ($U_S$) can be connected via the coupling impedance ($Z_k$).

## Revendications

1. Procédé pour accorder l'impédance ($Z_x$) d'un ensemble de bobine réceptrice dans la tête d'échantillonnage d'un spectromètre RMN avec un montage récepteur pour un signal RMN, procédé selon lequel, au moyen d'un signal d'accord HF (3), l'impédance ($Z_x$) de l'ensemble de bobine réceptrice est accordée, à l'aide d'un premier signal de référence produit avec une résistance de référence réelle ($R_0$), en un point de référence (M2) à l'intérieur du montage récepteur,
**caractérisé** en ce qu'une impédance de référence ($Z_0$), qui est séparée par une ou plusieurs impédances du chemin (9) du signal RMN, est ajustée de telle sorte qu'un deuxième signal de référence, correspondant au premier signal de référence au point de référence (M2), apparaît au point de référence (M2), et en ce que l'impédance ($Z_x$) de l'ensemble de bobine réceptrice est ensuite accordée au deuxième signal de référence au point de référence (M2).

2. Procédé selon la revendication 1, **caractérisé** en ce que le premier signal de référence est déterminé au moins une fois, et le deuxième signal de référence est périodiquement produit lors du processus d'ajustement de l'impédance de référence ($Z_0$).

3. Procédé selon la revendication 1 ou 2, **caractérisé** en ce que le deuxième signal de référence est déterminé au moins une fois, et le signal déterminé à l'aide de l'impédance ($Z_x$) de l'ensemble de bobine réceptrice est périodiquement produit lors du processus d'accord de l'impédance ($Z_x$) de l'ensemble de bobine réceptrice.

4. Procédé selon une des revendications précédentes, **caractérisé** en ce que le deuxième signal de référence est à nouveau déterminé au moins une fois au début du processus d'accord de l'impédance ($Z_x$) de l'ensemble de bobine réceptrice.

5. Montage pour la mise en oeuvre du procédé selon une des revendications 1 à 4, avec un générateur HF (2) pour produire le signal d'accord HF (3) et avec des éléments de commutation dans le chemin (9) du signal RMN, **caractérisé** en ce que l'impédance de référence ($Z_0$) est disposée en un endroit à l'intérieur du montage récepteur (10; 11) qui est séparé par une ou plusieurs impédances du chemin (9) du signal RMN.

6. Montage selon la revendication 5, **caractérisé** en ce que plusieurs impédances réglables ou réactances accordables sont disposées entre le générateur HF (2) et une impédance de couplage ($Z_k$) qui sépare l'impédance de référence ($Z_0$) du chemin du signal RMN.

7. Montage selon la revendication 6, **caractérisé** en ce que les réactances sont des condensateurs ajustables capacitifs.

8. Montage selon une des revendications 5 à 7, **caractérisé** en ce que l'impédance de référence ($Z_0$) est séparée du générateur HF (2) par un atténuateur (8).

9. Montage selon une des revendications 5 à 8, **caractérisé** en ce que l'impédance de référence ($Z_0$) est réalisée sous forme de résistance ($R_{Z0}$) variable parallèlement à un condensateur ajustable ($C_{Z0}$).

10. Montage selon une des revendications 5 à 9, **caractérisé** en ce qu'un ou plusieurs éléments de commutation (S0, S1, S2) sont disposés dans le chemin (9) du signal RMN.

11. Montage selon la revendication 9, **caractérisé** en ce qu'un courant continu provenant d'une source de tension ($U_S$) peut être mis en circuit par l'intermédiaire de l'impédance de couplage ($Z_k$).

FIG. 1

FIG. 2

FIG. 3

FIG. 4

FIG. 5

EP 0 696 743 B1

FIG. 6

FIG. 7

FIG. 8

FIG. 9

FIG. 10

EP 0 696 743 B1

FIG. 11